# FASCICULE DE BREVET EUROPEEN

(11) **EP 0 504 020 B1**
(45) Date de publication et mention de la délivrance du brevet: **26.10.1994**
(21) Numéro de dépôt: 92400585.3
(22) Date de dépôt: 06.03.1992
(51) Int. Cl.: H05K 9/00

(54) **Emetteur-récepteur hyperfréquence utilisant la technique des circuits imprimés multicouches**
Hochfrequenzsender-Empfänger unter Anwendung von mehrschichtigen gedruckten Schaltungen
High frequency transmitter-receiver using multilayer printed circuit technique

(30) Priorité: 12.03.1991 FR 9102953
(43) Date de publication de la demande: 16.09.1992
(73) Titulaire: THOMSON-TRT DEFENSE, 78280 Guyancourt (FR)
(72) Inventeur: Perret, François, F-92402 Courbevoie Cédex (FR); Podvin, Dominique, F-92402 Courbevoie Cédex (FR); Susset, Jean-Pierre, F-92402 Courbevoie Cédex (FR)
(74) Mandataire: Courtellemont, Alain

(56) Documents cités:
- EP-A- 0 394 053
- US-A- 4 739 453
- US-A- 4 890 199

## Description

La présente invention concerne les émetteurs-récepteurs en hyperfréquences et plus particulièrement ceux qui utilisent la technique des circuits imprimés pour leur ensemble émission-réception et filtrage hyperfréquence et pour leur ensemble modulation-démodulation. La réalisation de ces deux ensembles doit tenir compte du fait que l'émission-réception et le filtrage fonctionnent à une fréquence de quelques gigahertz alors que la fréquence de travail du modulateur-démodulateur est considérablement plus basse : de l'ordre de 100 kHz.

Compte-tenu de sa fréquence de travail, l'ensemble émission-réception et de filtrage doit être entièrement blindé et non seulement l'émission-réception doit être électro-magnétiquement isolée du filtrage mais, de plus, les circuits correspondant aux différentes fonctions relatives à l'émission-réception doivent être rigoureusement isolés les uns des autres.

De tels émetteurs-récepteurs sont connus par exemple du document EP-A- 0 394 053.

Des émetteurs-récepteurs fonctionnant en hyperfréquences sont connus dans lesquels, en ce qui concerne l'émission-réception, chaque fonction est réalisée sur un circuit imprimé individuel. Les différents circuits imprimés sont encastrés dans les alvéoles d'un bloc métallique taillé dans la masse ou obtenu par moulage puis usinage ; un ou plusieurs couvercles sont vissés sur le bloc pour fermer les alvéoles. Le filtre hyperfréquence, du type à résonateur, est enfermé dans une enceinte faite de deux demi-coquilles fixées sur le bloc métallique qui contient l'ensemble émission-réception. L'ensemble modulation-démodulation est monté sur un circuit imprimé qui lui est propre. Les connexions internes à l'ensemble émission-réception et filtrage se font par des trous percés dans les cloisons. Les connexions entre l'ensemble émission-réception et filtrage et le reste de l'émetteur, dont l'ensemble modulation-démodulation, se font en utilisant des circuits de découplage (by-pass, dans la littérature anglo-saxonne).

Du document US-A- 4 739 453 il est connu de construire de circuits hyperfréquences comprenant un circuit imprimé multicouche portant de demi coquilles métalliques interconnectées par des trous métallisés.

Ces réalisations connues d'émetteurs-récepteurs en hyperfréquences présentent certains inconvénients : du fait du nombre de pièces à assembler le montage et le démontage sont longs et les risques de fuites hyperfréquences sont importants ; de plus les connexions sont délicates à mettre en oeuvre entre les différents circuits imprimés.

La présente invention a pour but d'éviter ou, pour le moins, de réduire ces inconvénients.

Ceci est obtenu en utilisant un seul circuit imprimé pour monter aussi bien l'ensemble émission-réception et filtrage que l'ensemble modulation-démodulation ; de plus toutes les connexions concernant ces deux ensembles peuvent être réalisées dans le circuit imprimé, du moins jusqu'à un connecteur à plusieurs contacts, solidaire du circuit imprimé, lorsque la connexion concerne également un ensemble autre que les deux ensembles sus-indiqués.

La présente invention a pour objet un émetteur-récepteur hyperfréquence tel que défini par la revendication 1.

La présente invention sera mieux comprise et d'autres caractéristiques apparaîtront à l'aide de la description ci-après et des figures s'y rapportant, qui représentent :
- les figures 1 et 2 des vues en coupe de parties d'émetteurs-récepteurs selon l'invention,
- la figure 3, une vue en perspective d'éléments rentrant dans la réalisation d'un émetteur-récepteur selon l'invention.

Sur les figures les éléments correspondants sont désignés par les mêmes repères,

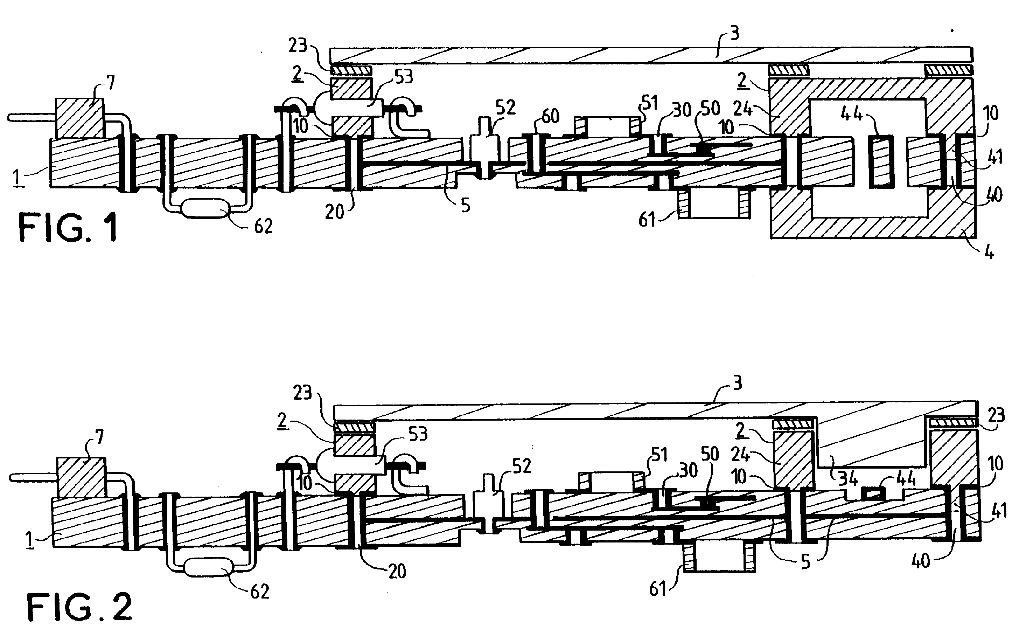

La figure 1 montre un circuit imprimé multicouche, 1, sur lequel sont montés différents composants ainsi que, sur sa face supérieure, un treillis métallique, conducteur, épais 2, fermé par un couvercle métallique 3 associé à un joint d'étanchéité électromagnétique 23. Sur la face inférieure du circuit 1 est montée une demi-coquille métallique, 4.

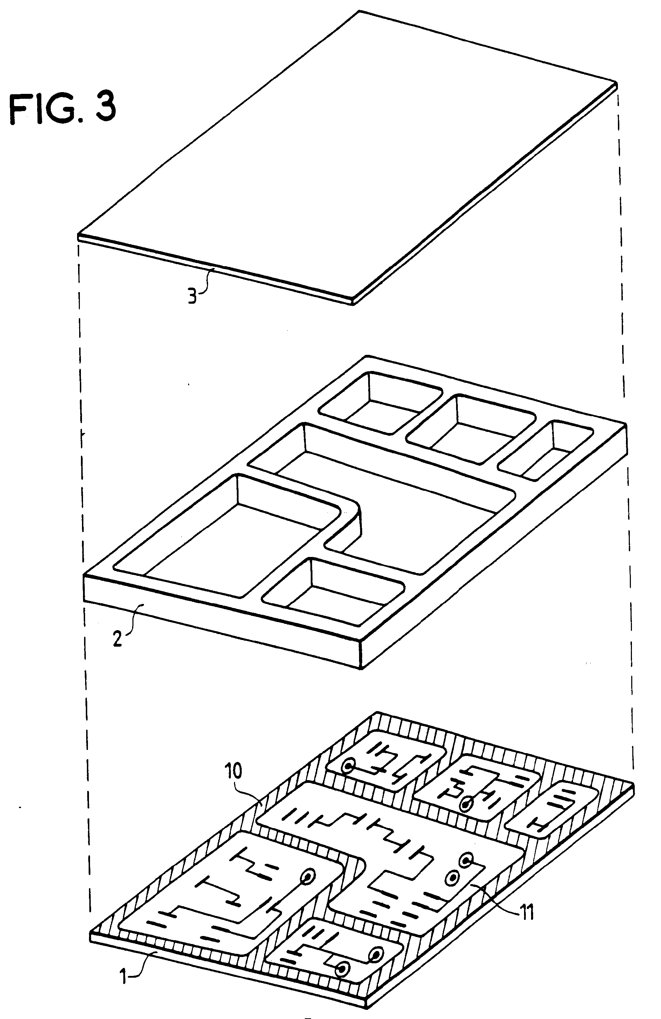

La figure 3 montre, vus en perspective et avant assemblage comment sont réalisés un circuit imprimé multicouche 1, un treillis conducteur épais 2 et un couvercle conducteur 3 destinés à un émetteur-récepteur selon l'invention, qui d'ailleurs n'est pas celui de la figure 1 ni même celui de la figure 2, ce qui permet de voir plus de réalisations et de noter leurs caractéristiques communes, qui sont :
- un circuit imprimé 1 dont la couche supérieure, qui sera dite couche support, comporte un quadrillage irrégulier, 10, fait de larges pistes conductrices, avec des liaisons conductrices, telles que 11, à l'intérieur des cases définies par ce quadrillage ; il est à noter que, pour simplifier le dessin, les trous métallisés tels que les trous 20 et 40 des figures 1 et 2, n'ont pas été représentés sur la figure 3 où ils seraient apparus comme un pointillé sensiblement positionné au milieu des pistes conductrices du quadrillage 10,
- un treillis conducteur 2, qui reproduit en épaisseur le dessin du quadrillage 10 et qui est destiné à être soudé sur ce quadrillage,
- un couvercle 3 aux dimensions extérieures du treillis sur lequel il est assemblé à l'aide d'un ensemble, non représenté, de vis qui traversent le couvercle pour pénétrer dans des trous filetés, percés dans le treillis. Le montage comporte de plus, de manière classique, un joint électromagnétique souple, non représenté, qui lui aussi reproduit le dessin du quadrillage 10 et est destiné à être monté entre le treillis et le couvercle ; un tel joint est représenté sur les figures 1 et 2 où il porte la référence 23 et où, pour bien distinguer le couvercle 3 du joint 23 et du treillis 2 ces trois éléments ont été légèrement écartés les uns des autres alors, qu'après montage au moyen de vis, ils sont parfaitement accolés.

Une partie du treillis 2 selon la figure 1 constitue une demi-coquille 24 et les deux demi-coquilles 4 et 24 sont disposées de manière à constituer une coquille. L'intérieur de cette coquille renferme un filtre hyperfréquence dont seul un bras de réactance 44 (stub, dans la littérature anglo-saxonne) apparaît sur la figure 1. Les bords des deux demi-coquilles sont reliés par des trous métallisés tels que 40, régulièrement disposés à environ 5 mm les uns des autres. Compte tenu d'une fréquence de travail de 4, 3 GHz pour le filtre que renferme la coquille, ces trous métallisés sont donc à une distance les uns des autres qui est inférieure au vingtième de la longueur d'onde de travail dans le substrat du circuit imprimé 1 ; ces trous forment donc un écran aux ondes hyperfréquences créées, à l'intérieur de la coquille, par le filtre.

D'autres trous métallisés tels que 20, également écartés les uns des autres d'environ 5 mm, font la liaison entre les autres parties du treillis, qui reposent sur le circuit imprimé 1, et une plaque conductrice 5. La plaque 5 constitue une couche interne partielle du circuit imprimé 1 ; elle est placée à l'aplomb du treillis 2 sauf à l'intérieur de la coquille, d'où elle est absente. Ainsi le treillis 2, le couvercle 3, les trous métallisés tels que 20 et la plaque 5 déterminent des volumes qui sont protégés sur le plan électromagnétique, comme l'est l'intérieur de la coquille 24-4 ; dans ces volumes protégés sont montés les circuits électroniques correspondant aux différentes fonctions de la partie émission-réception proprement dite de l'émetteur-récepteur considéré.

Les protections électromagnétiques qui entourent ainsi la partie émission-réception et le filtrage hyperfréquence, constituent, pour le milieu extérieur, un écran contre les perturbations hyperfréquences produites par les circuits situés à l'intérieur des volumes qu'elles délimitent. Ceci permet de monter la partie modulation-démodulation de l'émetteur-récepteur sur la face inférieure du circuit imprimé multicouche, là ou cette face n'est pas recouverte par la demi-coquille 4.

La figure 1 montre un certain nombre de composants montés sur le circuit imprimé : composant monté en surface 51 et composant à montage spécial 52 dans la partie hyperfréquence, composant monté en surface 61 et composant classique 62, dans la partie émission-réception. Les connexions entre la partie hyperfréquence et la partie modulation-démodulation sont assurées par des trous métallisés tels que 60 ou des trous métallisés associés à des circuits de découplage (by-pass dans la littérature anglo-saxonne) tels que le circuit 53.

Les liaisons avec le reste de l'émetteur-récepteur sont assurées par un connecteur multicontact ordinaire, 7, soudé sur le circuit imprimé,

Afin de faciliter l'assemblage entre le treillis et le circuit imprimé 1 et de le renforcer mécaniquement, le treillis comporte des pions, tels que 41, qui s'encastrent dans certains des trous métallisés, tels que 40, du quadrillage 10.

Par ailleurs il est à noter que celles des couches du circuit imprimé 1, qui sont situées du côté de la partie hyperfréquence, ont été réalisées en stratifié de polytétrafluoroéthylène, en raison des bonnes performances en hyperfréquence de cette matière, tandis que les autres couches ont été réalisées en stratifié de résine époxy, en raison du prix intéressant de ce stratifié de grande diffusion.

La figure 2 correspond à une variante de réalisation de l'émetteur-récepteur de la figure 1, dans laquelle la partie filtrage seule est différente. La demi-coquille 4 a été supprimée et remplacée par une couche conductrice dans le circuit imprimé, cette couche n'étant d'ailleurs que la couche 5 selon la figure 1, mais plus étendue de manière à venir à l'aplomb du filtre hyperfréquence ; dans cette variante la demi-coquille supérieure 24 est fermée par le couvercle 3 alors que dans la réalisation selon la figure 1 la demi-coquille 24 était d'un seul bloc, le couvercle 3 n'ayant donc aucun rôle de protection électromagnétique vis-à-vis du filtre hyperfréquence. Il est à remarquer de plus, que dans la réalisation selon la figure 2, le bras de réactance 44 est plus mince que dans la réalisation selon la figure 1 du fait qu'il ne peut prendre toute l'épaisseur du circuit ; c'est pourquoi afin de conserver la même fréquence de travail le volume de la cavité qui a déjà été réduit par la suppression de la demi-coquille inférieure l'est encore plus par une excroissance 34 du couvercle 3, excroissance qui est plus épaisse que le fond, parallèle au circuit imprimé 1, de la demi-coquille 24 selon la figure 1.

La présente invention n'est pas limitée aux exemples décrits, c'est ainsi que le treillis métallique peut être constitué de plusieurs mailles assemblées par exemple par soudure.

De même, la technologie du circuit imprimé, avec ses trous métallisés, permet l'insertion, en sandwich, d'un drain thermique : une plaque métallique peut, en effet, être disposée à l'intérieur de l'empilage des couches du circuit imprimé et cette plaque peut être constituée par la plaque 5 à condition de lui donner une épaisseur suffisante pour l'effet d'évacuation de calories recherché.

## Revendications

1. Emetteur-récepteur hyperfréquence comportant un premier ensemble relatif à la modulation-démodulation et un deuxième ensemble avec des premiers circuits hyperfréquences relatifs aux fonctions émission-réception et un second circuit hyperfréquence relatif à la fonction filtrage hyperfréquence, l'émetteur-récepteur comportant en outre:
- un circuit imprimé multicouche (1) avec une première face sur laquelle est monté le premier ensemble, avec une couche interne (5) constituée, au moins partiellement, par une plaque conductrice, avec une seconde face présentant des pistes conductrices (10), qui forment un quadrillage conducteur irrégulier définissant des cases, et des liaisons conductrices (11) à l'intérieur des cases, et avec des trous métallisés (20, 40) qui forment un pointillé dans les pistes et qui sont situés à des distances les uns des autres notablement inférieures aux longueurs d'onde de travail de l'émetteur-récepteur
- un treillis conducteur épais (2) comportant des parois qui reposent sur les pistes et les recouvrent entièrement
- et un couvercle conducteur (3) qui recouvre le treillis (2) ;
les circuits hyperfréquences (44, 51, 52) étant disposés dans les cases avec une relation biunivoque entre les cases et les fonctions ; et les pistes (10), le treillis (2), les trous métallisés (20, 40) et, au moins pour les fonctions émission-réception, la plaque (5) et le couvercle (3) formant des enveloppes qui déterminent des volumes de protection électromagnétique et qui enferment les circuits hyperfréquences.

2. Emetteur-récepteur selon la revendication 1, caractérisé en ce que la plaque conductrice (5) est limitée, en étendue, à la partie du circuit imprimé sur laquelle sont situés les circuits hyperfréquences (51,52) et en ce que l'enveloppe qui enferme le second circuit hyperfréquence comporte deux demi-coquilles (4, 24) dont la première (24) fait partie, au moins partiellement, du treillis (2) et dont la seconde (4) est disposée de l'autre côté du circuit imprimé (1) par rapport à la première.

3. Emetteur-récepteur selon la revendication 1, caractérisé en ce que la plaque conductrice (5) s'étend au moins dans toute la partie du circuit imprimé sur laquelle est monté le deuxième ensemble et en ce que l'enveloppe qui enferme le second circuit hyperfréquence comporte d'une part une demi-coquille (24, 3) qui fait partie, au moins partiellement, du treillis (2) et d'autre part la partie de la plaque (5) au dessus de laquelle se trouve la demi-coquille (24, 3).

4. Emetteur-récepteur selon la revendication 1, 2 ou 3, caractérisé en ce que le second circuit hyperfréquence comporte des bras de réactance (44) réalisés dans l'épaisseur du circuit imprimé (1).

5. Emetteur-récepteur selon la revendication 1, 2, 3 ou 4, caractérisé en ce qu'il comporte un connecteur multicontact (7) fixé au circuit imprimé (1) pour assurer les liaisons entre le premier et le deuxième ensemble et le reste de l'émetteur-récepteur.

## Patentansprüche

1. Höchstfrequenz-Sender-Empfänger mit einer ersten Einheit, die die Modulation/Demodulation betrifft, und einer zweiten Einheit mit ersten Höchstfrequenzschaltungen, die die Sende-/ Empfangsfunktionen betreffen, sowie einer zweiten Höchstfrequenzschaltung, die die Höchstfrequenzfilterfunktion betrifft, wobei der Sender-Empfänger ferner aufweist:
- eine mehrschichtige gedruckte Schaltung (1) mit einer ersten Seite, auf der die erste Einheit angebracht ist, mit einer inneren Schicht (5), die wenigstens teilweise durch eine leitende Platte gebildet ist, mit einer zweiten Seite, die Leiterbahnen (10), die ein unregelmäßiges Leiterraster bilden, das Fächer abgrenzt, und leitende Verbindungen (11) im Inneren der Fächer aufweist, sowie mit metallisierten Löchern (20, 40), die in den Bahnen ein Punktmuster bilden und voneinander in Abständen liegen, die merklich kleiner als die Arbeitswellenlängen des Sender-Empfängers sind;
- ein dickes leitendes Gitter (2) mit Wänden, die auf den Bahnen ruhen und sie vollständig überdecken;
- sowie einen leitenden Deckel (3), der das Gitter (2) überdeckt; wobei die Höchstfrequenzschaltungen (44, 51, 52) in den Fächern mit eineindeutiger Beziehung zwischen den Fächern und den Funktionen angeordnet sind, und wobei die Bahnen (10), das Gitter (2), die metallisierten Löcher (20, 40) und wenigstens für die Sende-/Empfangsfunktionen die Platte (5) und der Deckel (3) Umhüllungen bilden, die elektromagnetische Schutzräume bestimmen und die Höchstfrequenzschaltungen umschließen.

2. Sender-Empfänger nach Anspruch 1, dadurch gekennzeichnet, daß die leitende Platte (5) in der Ausdehnung auf den Teil der gedruckten Schaltung begrenzt ist, auf dem die Höchstfrequenzschaltungen (51, 52) liegen, und daß die die zweite Höchstfrequenzschaltung umschließende Umhüllung zwei Halbschalen (4, 24) aufweist, von denen die erste (24) wenigstens teilweise einen Teil des Gitters (2) bildet und die zweite (4) bezüglich der ersten an der anderen Seite der gedruckten Schaltung (1) angeordnet ist.

3. Sender-Empfänger nach Anspruch 1, dadurch gekennzeichnet, daß sich die leitende Platte (5) wenigstens in dem gesamten Teil der gedruckten Schaltung erstreckt, auf dem die zweite Einheit angebracht ist, und daß die die zweite Höchstfrequenzschaltung umschließende Umhüllung einerseits eine Halbschale (24, 3), die wenigstens teilweise einen Teil des Gitters (2) bildet, und andererseits den Teil der Platte (5) umfaßt, über dem sich die Halbschale (24, 3) befindet.

4. Sender-Empfänger nach Anspruch 1, 2 oder 3, dadurch gekennzeichnet, daß die zweite Höchstfrequenzschaltung Blindleitungen (44) aufweist, die in der Dicke der gedruckten Schaltung gebildet sind.

5. Sender-Empfänger nach Anspruch 1, 2, 3 oder 4, dadurch gekennzeichnet, daß er einen mehrpoligen Verbinder (7) aufweist, der an der gedruckten Schaltung (1) befestigt ist, um die Verbindungen zwischen der ersten und der zweiten Einheit und dem Rest des Sender-Empfängers zu gewährleisten.

## Claims

1. UHF transmitter/receiver including a first assembly relative to the modulation/demodulation, and a second assembly with first UHF circuits relative to the transmission/reception functions, and a second UHF circuit relative to the UHF filtering function, the transmitter/receiver further including:
- a multilayer printed circuit (1) with a first face on which the first assembly is mounted, with an internal layer (5) consisting, at least partially, of a conducting plate, with a second face having conducting tracks (10), which form an irregular conducting grid pattern defining boxes, and conducting links (11) within the boxes, and with metallized holes (20, 40) which form a dotted line in the tracks and which are situated at distances from one another which are markedly less than the working wavelengths of the transmitter/receiver
- a thick conducting trellis (2) including walls which rest on the tracks and completely cover them
- and a conducting cover (3) which covers the trellis (2);
the UHF circuits (44, 51, 52) being arranged in the boxes with a one-to-one relation between the boxes and the functions; and the tracks (10), the trellis (2), the metallized holes (20, 40) and, at least for the transmission/reception functions, the plate (5) and the cover (3) forming casings which define electromagnetic protection volumes and which enclose the UHF circuits.

2. Transmitter/receiver according to Claim 1, characterized in that the conducting plate (5) is limited, in extent, to the part of the printed circuit on which the UHF circuits (51, 52) are situated, and in that the casing which encloses the second UHF circuit includes two half-shells (4, 24) the first (24) of which forms part, at least partially, of the trellis (2) and the second (4) of which is arranged on the other side of the printed circuit (1) with respect to the first one.

3. Transmitter/receiver according to Claim 1, characterized in that the conducting plate (5) extends at least into all of the part of the printed circuit on which the second assembly is mounted, and in that the casing which encloses the second UHF circuit includes, on the one hand, a half-shell (24, 3) which forms part, at least partially, of the trellis (2) and, on the other hand, the part of the plate (5) above which the half-shell is located (24, 3).

4. Transmitter/receiver according to Claim 1, 2 or 3, characterized in that the second UHF circuit includes reactance arms (44) produced in the thickness of the printed circuit (1).

5. Transmitter/receiver according to Claim 1, 2, 3 or 4, characterized in that it includes a multi-contact connector (7) fixed to the printed circuit (1) in order to provide the links between the first and second assembly and the rest of the transmitter/receiver.
